(19) Europäisches Patentamt
European Patent Office
Office européen des brevets

(11) **EP 4 376 563 A1**

(12) **EUROPÄISCHE PATENTANMELDUNG**

(43) Veröffentlichungstag:
**29.05.2024 Patentblatt 2024/22**

(21) Anmeldenummer: **22209817.0**

(22) Anmeldetag: **28.11.2022**

(51) Internationale Patentklassifikation (IPC):
***H05K 5/06*** *(2006.01)*

(52) Gemeinsame Patentklassifikation (CPC):
**H05K 5/064**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder: **Murrelektronik GmbH
71570 Oppenweiler (DE)**

(72) Erfinder:
• **Wolff, Ingo
74613 Öhringen (DE)**

• **Illg, Thomas
73642 Welzheim (DE)**

(74) Vertreter: **Karzel, Philipp et al
Patentanwälte
Dipl.-Ing. W. Jackisch & Partner mbB
Menzelstraße 40
70192 Stuttgart (DE)**

Bemerkungen:
Geänderte Patentansprüche gemäss Regel 137(2)
EPÜ.

(54) **VORRICHTUNG MIT EINEM GEHÄUSE UND EINEM TRAGKÖRPER FÜR ELEKTRONISCHE BAUTEILE**

(57) Die Erfindung betrifft eine Vorrichtung umfassend ein Gehäuse (2) mit einer Gehäuseinnenwand (3), einen Tragkörper (4) für elektronische Bauteile (5) und eine Vergussmasse (6). Der Tragkörper (4) ist in dem Gehäuse (2) angeordnet. Die Vergussmasse (6) ist in dem Gehäuse (2) angeordnet. Der Tragkörper (4) ist zumindest teilweise in die Vergussmasse (6) eingegossen. Die Vergussmasse (6) liegt an der Gehäuseinnenwand (3) an. Die Vergussmasse (6) haftet an der Gehäuseinnenwand (3). Die Vergussmasse (6) haftet an dem Trag-körper (4). Die Vorrichtung (1) umfasst einen Zusatzkörper (7), der zwischen der Gehäuseinnenwand (3) und dem Tragkörper (4) angeordnet ist. Der Zusatzkörper (7) weist eine der Gehäuseinnenwand (3) zugewandte Gehäuseseite (16) auf. Zwischen der Gehäuseseite (16) des Zusatzkörpers (7) und der Gehäuseinnenwand (3) ist zumindest teilweise Vergussmasse (6) angeordnet. Das Material des Zusatzkörpers (7) ist so gewählt, dass sich die Vergussmasse (6) von dem Zusatzkörper (7) lösen kann.

*Fig. 4*

EP 4 376 563 A1

**Beschreibung**

Die Erfindung betrifft eine Vorrichtung nach dem Oberbegriff des Anspruchs 1.

Aus der DE 10 2011 086 048 A1 ist eine Vorrichtung bekannt mit einem Substrat zum Tragen einer elektrischen Schaltung, mit einem Gehäuse zum Einhausen des Substrats und mit einer im Gehäuse aufgenommenen Vergussmasse, die das Substrat umgibt. Um einen Spannungsabbau während des Aushärtens und Schwindens der Vergussmasse zu ermöglichen, weist das Gehäuse eine Wandung auf, von der sich die Vergussmasse lösen kann. Die Adhäsionskraft zwischen der Vergussmasse und der Oberfläche der Wandung ist geringer als die Adhäsionskraft zwischen der Vergussmasse und der Oberfläche des Substrats. Auf diese Weise kann zwischen der Vergussmasse und der Gehäusewandung ein Entspannungsspalt entstehen. Der Entspannungsspalt stellt gewissermaßen eine Solllösestelle dar, da dadurch vermieden werden kann, dass Ablösungen am Substrat, insbesondere von elektronischen Bauteilen, erfolgen. Dies wäre der Fall, wenn ein Entspannungsspalt eher am Substrat als an der Gehäusewandung entstünde. Ein solcher Entspannungsspalt an der Gehäusewandung bietet Raum für eindringenden Schmutz oder eindringende Flüssigkeiten, die insbesondere bei Temperaturschwankungen zur Beschädigung der Vorrichtung führen können.

Der Erfindung liegt die Aufgabe zugrunde, eine gattungsgemäße Vorrichtung derart weiterzubilden, dass eine Beschädigung der Vorrichtung umfassend das Gehäuse und den Tragkörper für elektronische Bauteile sicher vermieden ist. Eine solche Beschädigung kann beispielsweise durch das Eindringen von Schmutz oder Flüssigkeiten oder durch das Ablösen von elektronischen Bauteilen von Tragkörper erfolgen.

Diese Aufgabe wird durch eine Vorrichtung mit den Merkmalen des Anspruchs 1 gelöst.

Erfindungsgemäß ist der Tragkörper zumindest teilweise in die Vergussmasse eingegossen. Es kann auch vorgesehen sein, dass der Tragkörper vollständig in die Vergussmasse eingegossen ist. Die Vergussmasse liegt an der Gehäuseinnenwand an. Insbesondere kann die Vergussmasse vollständig an der Gehäuseinnenwand anliegen. Insbesondere sind zwischen der Gehäuseinnenwand und der Vergussmasse keine Hohlräume ausgebildet. Die Vergussmasse haftet an der Gehäuseinnenwand und an dem Tragkörper. Nach der Erfindung ist vorgesehen, dass die Vorrichtung einen Zusatzkörper umfasst. Der Zusatzkörper ist zwischen der Gehäuseinnenwand und dem Tragkörper angeordnet. Der Zusatzkörper weist eine der Gehäuseinnenwand zugewandte Gehäuseseite auf. Zwischen der Gehäuseseite des Zusatzkörpers und der Gehäusesinnenwand ist zumindest teilweise Vergussmasse angeordnet. Das Material des Zusatzkörpers ist so gewählt, dass sich die Vergussmasse von dem Zusatzkörper lösen kann. Insbesondere ist das Material des Zusatzkörpers so gewählt, dass sich die Vergussmasse während des Schwindens der Vergussmasse beim Aushärten der Vergussmasse zumindest von einem Teil des Zusatzkörpers lösen kann. Dadurch kann ein Entspannungsspalt zwischen dem Zusatzkörper und der Vergussmasse entstehen. Insbesondere ist der Entspannungsspalt vollständig in die Vergussmasse eingeschlossen. Bevorzugt ist der Entspannungsspalt allseitig von Vergussmasse umgeben. Beim Lösen der Vergussmasse von dem Zusatzkörper löst sich die Vergussmasse zumindest von dem überwiegenden Teil der Masse des Zusatzkörpers. Der Begriff Lösen umfasst, dass die schwindende Vergussmasse einen geringen Anteil der Masse des Zusatzkörpers mitnehmen kann und sich gemeinsam mit diesem geringen Anteil von einem Hauptteil des Zusatzkörpers entfernen kann.

Der geringe Anteil der Masse des Zusatzkörpers, der von der schwindenden Vergussmasse mitgenommen werden kann, umfasst eine Masse von bis zu 5% der Gesamtmasse des Zusatzkörpers. Der Begriff Lösen umfasst aber auch ein vollständiges Lösen der Vergussmasse von dem Zusatzkörper, ohne dass ein geringer Teil des Zusatzkörpers von der schwindenden Vergussmasse mitgenommen wird.

Dadurch, dass sich die Vergussmasse von dem Zusatzkörper lösen kann, kann eine Beschädigung der Vorrichtung vermieden werden. Es kann vermieden werden, dass durch eine Spaltbildung zwischen dem Tragkörper und der Vergussmasse eine Beschädigung des Tragkörpers oder der von ihm getragenen elektronischen Bauteile erfolgt. Weiterhin kann vermieden werden, dass aufgrund eines Spalts zwischen der Gehäuseinnenwand und der Vergussmasse Schmutz oder Flüssigkeiten in den Spalt zwischen Gehäuseinnenwand und Vergussmasse eindringen und auf diese Weise die Vorrichtung beschädigen. Der Entspannungsspalt kann aufgrund des Zusatzkörpers entfernt von den kritischen Stellen entstehen. Insbesondere kann der Entspannungsspalt vollständig von Vergussmasse eingeschlossen sein. Dadurch ist auf sichere Weise vermieden, dass Schmutz oder Flüssigkeiten in den Entspannungsspalt vordringen können.

Am Zusatzkörper ist insbesondere eine Solllösestelle für Vergussmasse ausgebildet. Beim Aushärten der Vergussmasse muss sich die Vergussmasse dort nicht lösen. Die Vorrichtung weist daher nicht zwingend einen Entspannungsspalt auf. Bevorzugt ist die Vorrichtung aber so ausgelegt, dass sich die Vergussmasse, wenn sie sich von den sie umgebenden Bauteilen löst, an der durch den Zusatzkörper ausgebildeten Solllösestelle löst. Die Solllösestelle ist eine vordefinierte Stelle für die Bildung eines Entspannungsspalts.

Vorteilhaft ist das Material des Zusatzkörpers so gewählt, dass sich die Vergussmasse eher von dem Zusatzkörper als von der Gehäuseinnenwand löst. Vorteilhaft ist das Material des Zusatzkörpers so gewählt, dass sich die Vergussmasse eher von dem Zusatzkörper als von dem Tragkörper löst. Insbesondere ist das Material des Zusatzkörpers so gewählt, dass sich die Vergussmasse eher von dem Zusatzkörper als von der Gehäuseinnenwand und dem Tragkörper löst. Auf diese Weise kann sichergestellt werden, dass der Entspannungsspalt am ehesten zwischen der Vergussmasse und dem Zusatzkörper ausgebildet wird. Insbesondere ist das Material des Zusatzkörpers so gewählt, dass sich die Vergussmasse leichter von dem Zusatzkörper als von der Gehäuseinnenwand und/oder dem Tragkörper löst.

Zweckmäßig ist die Vorrichtung so ausgebildet, dass zum Lösen der Vergussmasse von dem Tragkörper eine erste Lösekraft erforderlich ist, dass zum Lösen der Vergussmasse von dem Tragkörper eine zweite Lösekraft erforderlich ist und dass die zweite Lösekraft kleiner als die erste Lösekraft ist. Insbesondere ist die zweite Lösekraft kleiner als die erste Lösekraft während des Schwindens der Vergussmasse beim Aushärten der Vergussmasse.

Insbesondere haftet die Vergussmasse am Tragkörper mit einer ersten Haltekraft. Insbesondere haftet die Vergussmasse am Zusatzkörper mit einer zweiten Haltekraft. Bevorzugt ist die zweite Haltekraft kleiner als die erste Haltekraft. Durch die beschriebenen Kräfteverhältnisse ist sichergestellt, dass sich die Vergussmasse während des Aushärtens eher von dem Zusatzkörper als von dem Tragkörper löst.

Insbesondere ist zum Lösen der Vergussmasse von der Gehäuseinnenwand eine dritte Lösekraft erforderlich. Insbesondere haftet die Vergussmasse an der Gehäuseinnenwand mit einer dritten Haltekraft. Vorzugsweise ist die zweite Lösekraft kleiner als die dritte Lösekraft. Bevorzugt ist die zweite Haltekraft kleiner als die dritte Haltekraft. Dadurch ist sichergestellt, dass sich die Vergussmasse während des Aushärtens eher von dem Zusatzkörper als von der Gehäuseinnenwand löst.

Zweckmäßig ist zwischen dem Zusatzkörper und der Gehäuseinnenwand ein erster Hohlraum für die Vergussmasse ausgebildet. In diesen ersten Hohlraum kann die Vergussmasse während des Vergießens der Vergussmasse fließen. Zweckmäßig ist zwischen dem Zusatzkörper und dem Tragkörper ein zweiter Hohlraum für die Vergussmasse ausgebildet. In diesen zweiten Hohlraum kann die Vergussmasse während des Vergießens der Vergussmasse fließen.

Der Zusatzkörper besitzt eine Gesamtaußenfläche. In vorteilhafter Weiterbildung der Erfindung liegen weniger als 40% der Gesamtaußenfläche an der Gehäuseinnenwand an. Insbesondere liegen weniger als 30% der Gesamtaußenfläche an der Gehäuseinnenwand an. Bevorzugt liegen weniger als 20% der Gesamtaußenfläche an der Gehäuseinnenwand an. Dadurch kann Vergussmasse zwischen den Zusatzkörper und die Gehäuseinnenwand vordringen.

In vorteilhafter Weiterbildung der Erfindung umfasst der Zusatzkörper eine Abstützfläche zur Abstützung an der Gehäuseinnenwand und eine Hauptfläche. Zweckmäßig ist die Vorrichtung so ausgebildet, dass bei Anlage der Abstützfläche an der Gehäuseinnenwand die Hauptfläche in einem Abstand zur Gehäuseinnenwand angeordnet ist. Mittels der Abstützfläche kann der Zusatzkörper auf einfache Weise an der Gehäuseinnenwand angeordnet sein. Durch den Abstand der Hauptfläche der Gehäuseinnenwand kann auf einfache Weise ein Hohlraum zwischen der Gehäuseinnenwand und der Hauptfläche ausgebildet sein.

Vorteilhaft ist die Vorrichtung so ausgebildet, dass bei Anlage der Abstützfläche an der Gehäuseinnenwand die Hauptfläche in einem Abstand zu dem Tragkörper angeordnet ist. Dadurch kann auf einfache Weise ein Hohlraum zwischen dem Zusatzkörper und dem Tragkörper ausgebildet sein.

Zweckmäßig besteht die Vergussmasse im gesamten Bereich zwischen der Gehäuseinnenwand und dem Tragkörper aus derselben Werkstoffzusammensetzung. Insbesondere besteht die Vergussmasse in einem Bereich, der den Zusatzkörper vollständig einschließt, aus derselben Werkstoffzusammensetzung. Zweckmäßig besteht die Vergussmasse im gesamten Bereich zwischen der Gehäuseinnenwand und dem Tragkörper aus einem einzigen Material. Dadurch lässt sich die Vorrichtung auf einfache und unkomplizierte Weise herstellen. Sowohl der Tragkörper als auch der Zusatzkörper können in einem einzigen Vergussschritt in das Gehäuse der Vorrichtung eingegossen werden. Während des Aushärtens besitzt die Vergussmasse im gesamten Bereich zwischen der Gehäuseinnenwand und dem Tragkörper in dem Bereich, der den Zusatzkörper vollständig einschließt, dieselben Eigenschaften bezüglich des Schwindens und der Lösekräfte, insbesondere vom Tragkörper, vom Zusatzkörper und von der Gehäuseinnenwand. Dadurch ergeben sich ein isotropes Schwindverhalten und ein einheitliches Schwindmaß. Vorteilhaft besitzt die Vergussmasse im gesamten Bereich zwischen der Gehäuseinnenwand und dem Tragkörper, insbesondere in dem Bereich, der den Zusatzkörper vollständig einschließt, einen einzigen Härtewert.

Zweckmäßig weist der Zusatzkörper mindestens eine Durchlassöffnung für die Vergussmasse auf. Insbesondere durchdringt die Durchlassöffnung den Zusatzkörper vollständig. Dadurch kann die Vergussmasse während des Vergießens der Vergussmasse von der einen Seite des Zusatzkörpers durch die Durchlassöffnung auf die andere Seite des Zusatzkörpers vordringen. Dadurch kann beispielsweise ein Hohlraum zwischen der Gehäuseinnenwand und dem Zusatzkörper zuverlässig mit Vergussmasse gefüllt werden.

In vorteilhafter Weiterbildung der Erfindung ist vorgesehen, dass der Zusatzkörper zumindest teilweise aus einem Material mit einer Wärmeleitfähigkeit von mindestens $0{,}04\frac{\mathrm{W}}{\mathrm{m}\cdot\mathrm{K}}$ besteht. Das Material kann auch als Werkstoffzusammensetzung bezeichnet werden. Insbesondere besteht der Zusatzkörper vollständig aus einem Material mit einer Wärmeleitfähigkeit von mindestens

$$0,04 \ \frac{W}{m \cdot K}$$

. Vorteilhaft besteht der Zusatzkörper zumindest teilweise, insbesondere vollständig aus einem Material mit einer Wärmeleitfähigkeit von mindestens

$$0,08 \ \frac{W}{m \cdot K}$$

, insbesondere von mindestens $0,1 \ \frac{W}{m \cdot K}$

. Dadurch weist der Zusatzkörper nur eine sehr geringe Wärmeisolierungsfähigkeit auf. Hitze, die beispielsweise durch die elektronischen Bauteile des Tragkörpers entsteht, kann über den Zusatzkörper abtransportiert werden. Der Zusatzkörper leitet die Wärme weiter, ohne dass ein Wärmestau entsteht. Dies verhindert eine Beschädigung der Vorrichtung, insbesondere des von dem Tragkörper getragenen elektronischen Bauteils.

Bevorzugt besteht der Zusatzkörper zumindest teilweise aus Papier, Metall oder Kunststoff. Insbesondere besteht der Zusatzkörper vollständig aus Papier, Metall oder Kunststoff. Zweckmäßig ist der Kunststoff Teflon oder Silikon. Es kann auch vorgesehen sein, dass der Zusatzkörper zumindest teilweise, insbesondere vollständig aus Kunststofffolie besteht.

Die Gehäuseinnenwand weist eine Gesamtinnenfläche auf. Insbesondere liegt der Zusatzkörper mit einer Gesamtanlagefläche an der Gehäuseinnenwand an. In vorteilhafter Weiterbildung der Erfindung ist vorgesehen, dass die Gesamtanlagefläche weniger als 10% der Gesamtinnenfläche beträgt. Zweckmäßig beträgt die Gesamtanlagefläche weniger als 5% der Gesamtinnenfläche. Dadurch kann die Vergussmasse einen sehr großen Anteil der Gesamtinnenfläche abdecken. Dadurch ist gewährleistet, dass das Zusammenspiel von Vergussmasse und Gehäuseinnenwand die Vorrichtung vor eindringenden Flüssigkeiten oder Schmutz schützen kann. Da aufgrund der erfindungsgemäßen Gestaltung der Vorrichtung keine Spalte zwischen der Vergussmasse und der Gehäuseinnenwand entstehen können und die Vergussmasse über einen sehr großen Bereich der Gesamtinnenfläche an der Gehäuseinnenwand anliegt, ist eine saubere und beschädigungsarme Gestaltung der Vorrichtung möglich.

Ein Ausführungsbeispiel der Erfindung wird im Folgenden anhand der Zeichnung erläutert. Es zeigen:

Fig. 1 eine Explosionsdarstellung einer Vorrichtung mit einem Gehäuse, einem Tragkörper und einem Zusatzkörper,

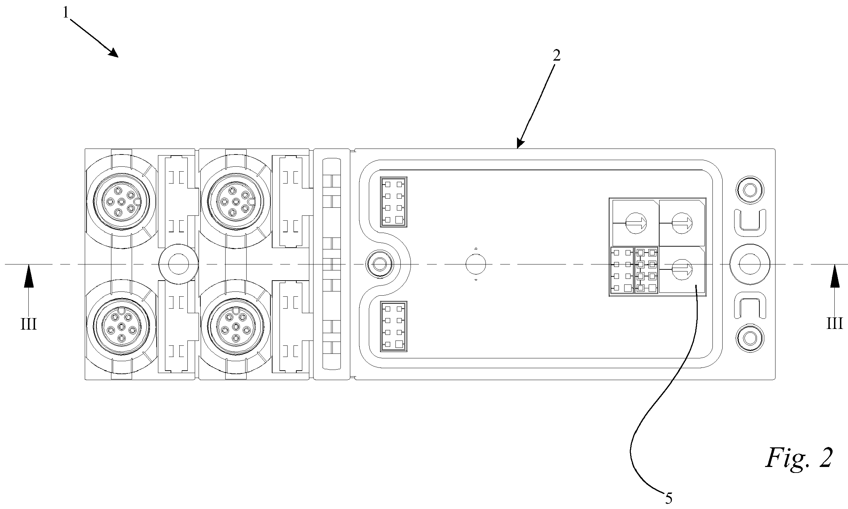

Fig. 2 eine Draufsicht von unten auf das Gehäuse der Vorrichtung aus Fig. 1,

Fig. 3 eine Schnittdarstellung eines Schnitts entlang der in Fig. 2 dargestellten Schnittlinie III-III und

Fig. 4 eine schematische Schnittdarstellung der Vorrichtung aus Fig. 1 entsprechend der Fig. 3.

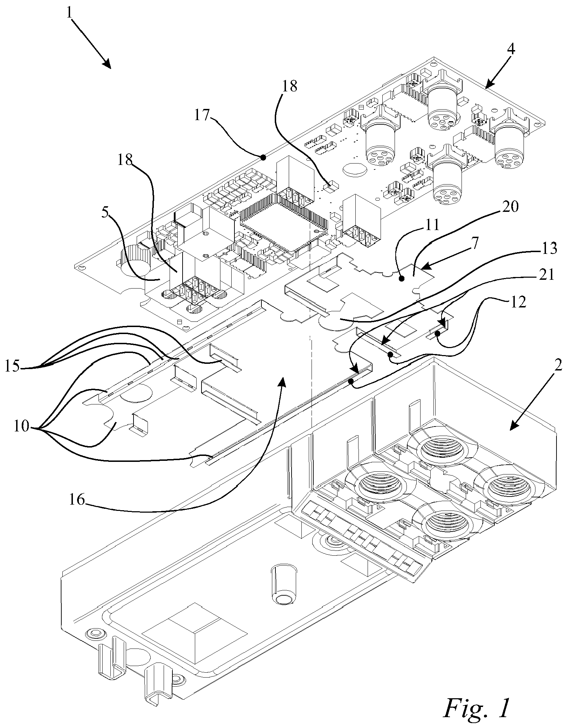

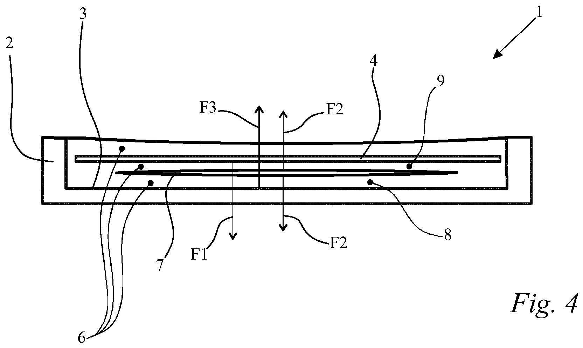

Fig. 1 zeigt eine Vorrichtung 1. Die Vorrichtung 1 umfasst ein Gehäuse 2, einen Tragkörper 4 und einen Zusatzkörper 7. Der Tragkörper 4 trägt mindestens ein elektronisches Bauteil 6. Das elektronische Bauteil 5 ist am Tragkörper 4 befestigt. Der Tragkörper 4 wird auch als Leiterplatte bezeichnet. Im Ausführungsbeispiel trägt der Tragkörper 4 eine elektrische Schaltung. Das elektronische Bauteil 5 ist im Ausführungsbeispiel Bestandteil der elektrischen Schaltung. Der Tragkörper 4 ist in eine in Fig. 4 dargestellte Vergussmasse 6 zumindest teilweise, im Ausführungsbeispiel vollständig eingegossen. Der Tragkörper 4 ist in dem Gehäuse 2 angeordnet. Die Vergussmasse 6 ist in dem Gehäuse 2 angeordnet.

Das Gehäuse 2 wird auch als Vergussbecher bezeichnet. Das Gehäuse 2 ist im Wesentlichen becherförmig. Das Gehäuse 2 dient zur Aufnahme des Tragkörpers 4 und des mindestens einen elektronischen Bauteils 5. In das Gehäuse 2 wird bei der Herstellung der Vorrichtung 1 die Vergussmasse 6 gegossen. Durch die Vergussmasse 6 werden der Tragkörper 4 und das elektronische Bauteil 5 geschützt. Insbesondere werden der Tragkörper 4 und das elektronische Bauteil 5 durch die Vergussmasse 6 elektrisch isoliert.

Das Gehäuse 2 besitzt eine Gehäuseinnenwand 3. Die Gehäuseinnenwand 3 bildet die Innenseite des Gehäuses 2, insbesondere des im Wesentlichen becherförmigen Gehäuses 2. Die Gehäuseinnenwand 3 ist der Teil des Gehäuses 2, der einen Aufnahmeraum für die Vergussmasse 6 begrenzt. Die Gehäuseinnenwand 3 ist im Ausführungsbeispiel durch einen Boden des Gehäuses und vier Seitenwände gebildet. Dadurch ist die Gehäuseinnenwand 3 im Wesentlichen becherförmig. Es kann aber auch eine anders geformte Gehäuseinnenwand vorgesehen sein. Beispielsweise kann die Gehäuseinnenwand einen Boden und eine daran anschließende umlaufende Umfangswand aufweisen. Die umlaufende Umfangswand stellt eine Mantelfläche, insbesondere eine zylinder-ähnliche Mantelfläche dar.

Die Vergussmasse 6 liegt an der Gehäuseinnenwand 3 an. Die Vergussmasse 6 haftet an der Gehäuseinnenwand 3. Die Vergussmasse 6 ist Bestandteil der Vorrichtung 1.

Das elektronische Bauteil 5 ist zumindest teilweise, insbesondere vollständig zwischen der Gehäuseinnenwand 3 und dem Tragkörper 4 angeordnet.

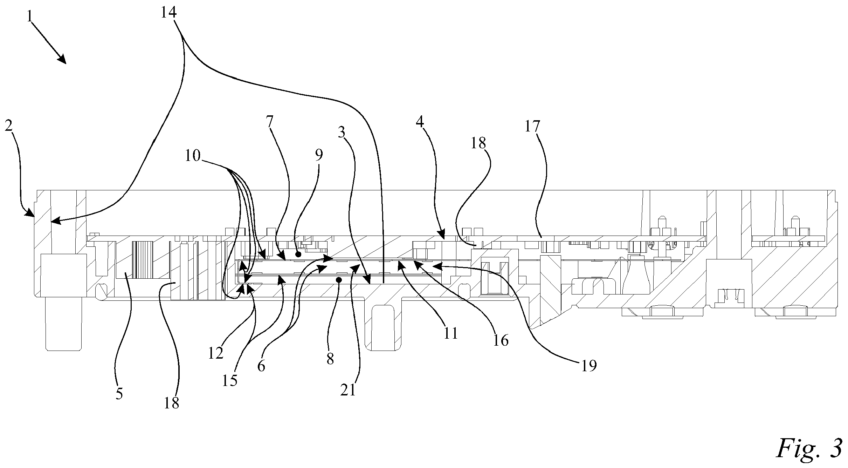

Während der Herstellung der Vorrichtung 1 wird der Tragkörper 4 mit dem elektronischen Bauteil 5 zunächst in dem Gehäuse 2 positioniert. Hierbei wird der Tragkörper 4 im Inneren des Gehäuses 2 angeordnet. Die Gehäuseinnenwand 3 des Gehäuses 2 umschließt den Tragkörper 4 zumindest teilweise. Der Tragkörper 4 weist einen Grundkörper 17 und Vorsprünge 18 auf. Die Vorsprünge 18 stehen über den Grundkörper 17 hervor. Die Vorsprünge 18 können auch durch elektronische Bauteile gebildet sein. Es kann aber auch vorgesehen sein, dass der Tragkörper 4 keine Vorsprünge aufweist. Stattdessen kann die Gehäuseinnenwand Vorsprünge aufweisen, an denen sich der Tragkörper abstützen kann. Zwischen dem Grundkörper 17 und der Gehäuseinnenwand 3 ist ein in Fig. 3 dargestellter Leerraum 19 ausgebildet.

Nach der Positionierung des Tragkörpers 4 im Gehäuse 2 wird die Vergussmasse 6 in das Gehäuse 2 vergossen. Beim Aushärten der Vergussmasse 6 schwindet die Vergussmasse 6. Unter einem Aushärten der Vergussmasse 6 ist ein Phasenübergang zwischen dem flüssigen Zustand der Vergussmasse 6 und dem festen Zustand der Vergussmasse 6 zu verstehen. Es kann vorgesehen sein, dass das Vergießen der Vergussmasse 6 und/oder das Aushärten der Vergussmasse 6 zur Vermeidung von Lufteinschlüssen in der Vergussmasse 6 unter Anliegen eines Vakuums erfolgt. Die Vergussmasse 6 verringert während des Aushärtens ihr Volumen. Im Stand der Technik kann es hierbei zu einem Abreißen der Vergussmasse 6 von der Gehäuseinnenwand 3 und/oder von dem Tragkörper 4, insbesondere von dem Grundkörper 17 kommen. Dabei entstehen an der Außenseite des Volumens der Vergussmasse 6 Spalte, insbesondere zwischen der Vergussmasse 6 und der Gehäuseinnenwand 3 und zwischen der Vergussmasse 6 und dem Tragkörper 4. In diesen Spalten aus dem Stand der Technik kann sich Schmutz oder auch Flüssigkeit sammeln. Insbesondere Flüssigkeit kann insbesondere bei Temperaturschwankungen Beschädigungen des Gehäuses oder auch der elektronischen Bauteile bewirken.

Eine solche Beschädigung wird erfindungsgemäß durch das Einbringen eines Zusatzkörpers 7 vermieden. Der Zusatzkörper 7 wird vor dem Vergießen der Vergussmasse 6 im Gehäuse 2 angeordnet. In der fertigen Vorrichtung 1 ist der Zusatzkörper 7 zwischen der Gehäuseinnenwand 3 und dem Tragkörper 4 angeordnet. Insbesondere ist der Zusatzkörper 7 zwischen der Gehäuseinnenwand 3 und dem Grundkörper 17 des Tragkörpers 4 angeordnet. Der Zusatzkörper 7 weist eine der Gehäuseinnenwand 3 zugewandte Gehäuseseite 16 auf. Bei der fertigen Vorrichtung 1 ist zwischen der Gehäuseseite 16 des Zusatzkörpers 7 und der Gehäuseinnenwand 3 zumindest teilweise Vergussmasse 6 angeordnet. Während des Vergießens der Vergussmasse 6 kann die Vergussmasse 6 in den Bereich zwischen der Gehäuseinnenwand 3 und der Gehäuseseite 16 des Zusatzkörpers 7 vordringen.

Das Material des Zusatzkörpers 7 ist so gewählt, dass sich die Vergussmasse 6 von dem Zusatzkörper 7 lösen kann. Insbesondere kann sich die Vergussmasse 6 während des Aushärtens der Vergussmasse 6 von dem Zusatzkörper 7 lösen. Im Ausführungsbeispiel löst sich die Vergussmasse 6 während des Aushärtens zumindest teilweise von dem Zusatzkörper 7. Es kann aber auch vorgesehen sein, dass sich die Vergussmasse 6 während des Aushärtens der Vergussmasse 6 vollständig von dem Zusatzkörper 7 löst. Auf diese Weise kann sich zwischen dem Zusatzkörper 7 und der Vergussmasse 6 ein Entspannungsspalt ausbilden. Im Ausführungsbeispiel ist ein solcher Entspannungsspalt zwischen dem Zusatzkörper 7 und der Vergussmasse 6 ausgebildet. Der Entspannungsspalt ist in den Figuren nicht dargestellt. Es kann vorgesehen sein, dass sich die Vergussmasse 6 beim Lösen vom Zusatzkörper 7 vollständig löst. Es kann aber auch vorgesehen sein, dass sich die Vergussmasse 6 vom Zusatzkörper 7 so löst, dass sich ein kleiner Teil des Zusatzkörpers 7 von dem restlichen Teil des Zusatzkörpers 7 zusammen mit der Vergussmasse 6 entfernt. Dieser kleine Teil beträgt jedoch lediglich einen geringen Anteil an der Gesamtmasse des Zusatzkörpers 7. Der Anteil lässt sich auf weniger als 5% der Gesamtmasse des Zusatzkörpers 7 beziffern. Ein Ablösen in dieser Form kann beispielsweise dann gegeben sein, wenn der Zusatzkörper aus Papier besteht und beim Lösen der Vergussmasse 6 vom Zusatzkörper 7 einzelne Papierfasern in der Vergussmasse 6 verbleiben.

Durch die gezielte Anordnung eines Entspannungsspalts zwischen der Vergussmasse 6 und dem Zusatzkörper 7 kann vermieden werden, dass zwischen der Vergussmasse 6 und der Außenfläche der Vergussmasse 6 ein Spalt entsteht. Im Ausführungsbeispiel liegt die Vergussmasse 6 spaltfrei an der Gehäuseinnenwand 3 an. Im Ausführungsbeispiel liegt die Vergussmasse 6 spaltfrei am Tragkörper 4 an.

Im Ausführungsbeispiel schließt die Vergussmasse 6 den nicht dargestellten Entspannungsspalt vollständig ein. Der Entspannungsspalt ist allseitig von Vergussmasse 6 umgeben. Der Entspannungspalt ist im Inneren der Vergussmasse 6 ausgebildet. Dadurch liegt der Entspannungsspalt geschützt vor Schmutz und Flüssigkeit.

Der Entspannungsspalt ist ausschließlich von der Vergussmasse 6 und dem Zusatzkörper 7 begrenzt. Der Entspannungsspalt grenzt unmittelbar an die Vergussmasse 6 und den Zusatzkörper 7 an.

In alternativer Ausführung kann auch vorgesehen sein, dass der Zusatzkörper vollständig in der der Vergussmasse eingeschlossen ist.

Das Material des Zusatzkörpers 7 ist so gewählt, dass sich die Vergussmasse 6 eher von dem Zusatzkörper 7 als von der Gehäuseinnenwand 3 löst. Das Material des Zusatzkörpers 7 ist so gewählt, dass sich die Vergussmasse 6 eher von dem Zusatzkörper 7 als von dem Tragkörper 4 löst. Insbesondere ist das Material des Zusatzkörpers 7 so gewählt, dass sich die Vergussmasse 6 eher von dem Zusatzkörper 7 als von dem Grundkörper 17 des Tragkörpers 4 löst. Beim Aushärten der Vergussmasse 6 löst sich die Vergussmasse 6 leichter von dem Zusatzkörper 7 als von der Gehäuseinnenwand 3 und/oder dem Tragkörper 4.

Wie in Fig. 4 dargestellt, ist zum Lösen der Vergussmasse 6 von dem Tragkörper 4 während des Aushärtens der Vergussmasse 6 eine erste Lösekraft F1 erforderlich. Zum Lösen der Vergussmasse 6 von dem Zusatzkörper 7 während des Aushärtens der Vergussmasse 6 ist eine zweite Lösekraft F2 erforderlich. Die zweite Lösekraft F2 ist kleiner als die erste Lösekraft F1. Vor dem Lösen der Vergussmasse 6 von dem Zusatzkörper 7 haftet die Vergussmasse 6 mit einer ersten Haltekraft am Tragkörper 4. Vor dem Lösen der Vergussmasse 6 von dem Zusatzkörper 7 haftet die Vergussmasse 6 mit einer zweiten Haltekraft an dem Zusatzkörper 7. Die zweite Haltekraft ist kleiner als die erste Haltekraft.

Zum Lösen der Vergussmasse 6 von der Gehäuseinnenwand 3 während des Aushärtens der Vergussmasse 6 ist eine dritte Lösekraft F3 erforderlich. Die zweite Lösekraft F2 ist kleiner als die dritte Lösekraft F3. Während des Aushärtens der Vergussmasse 6 haftet die Vergussmasse 6 an der Gehäuseinnenwand 3 mit einer dritten Haltekraft. Die zweite Haltekraft ist kleiner als die dritte Haltekraft.

Insbesondere kann es sich bei den Haltekräften um Adhäsionskräfte handeln. Zum Lösen der Vergussmasse 6 mittels der jeweiligen Lösekraft muss die entsprechende Haltekraft überwunden werden.

Wie in Fig. 1 dargestellt, umfasst der Zusatzkörper 7 eine Abstützfläche 12. Die Abstützfläche 12 dient zur Abstützung des Zusatzkörpers 7 an der Gehäuseinnenwand 3. Die Abstützfläche 12 ist im Ausführungsbeispiel ausschließlich die Fläche des Zusatzkörpers 7, die - zumindest vor dem Vergießen der Vergussmasse 6 - unmittelbar an der Gehäuseinnenwand 3 des Gehäuses 2 anliegt. Es kann alternativ auch vorgesehen sein, dass sich der Zusatzkörper mit der Abstützfläche an dem Tragkörper abstützt. In alternative Ausgestaltung kann vorgesehen sein, dass der Tragkörper oder das Gehäuse Stützelemente mit Stützflächen für den Zusatzkörper aufweisen. Ein Stützelement des Tragkörpers kann beispielsweise durch ein elektronisches Bauteil gebildet sein. Der Zusatzkörper 7 umfasst eine Hauptfläche 11. Die Hauptfläche 11 ist die Außenfläche eines Hauptkörpers 20 des Zusatzkörpers 7. Die Hauptfläche 11 ist sowohl dem Tragkörper 4 als auch der Gehäuseinnenseite 3 des Gehäuses 2 zugewandt. Die Hauptfläche 11 weist zwei in entgegengesetzte Richtungen zeigende Seiten auf. Die Hauptfläche 11 des Hauptkörpers 20 ist zwischen dem Tragkörper 4 und der Gehäuseinnenwand 3 angeordnet.

Wie in Fig. 3 dargestellt, ist die Vorrichtung 1 so ausgebildet, dass bei Anlage der Abstützfläche 12 an der Gehäuseinnenwand 3 die Hauptfläche 11 in einem Abstand zur Gehäuseinnenwand 3 angeordnet ist. Im Ausführungsbeispiel ist der Abstand quer, insbesondere senkrecht zu einem Boden des Gehäuses 2 gemessen. Die Hauptfläche 11 weist einen Abstand zu dem Boden des Gehäuses 2 auf. Aufgrund des Abstands zwischen der Hauptfläche 11 und der Gehäuseinnenwand 3 kann Vergussmasse 6 in den Bereich zwischen die Hauptfläche 11 und die Gehäuseinnenwand 3 fließen.

Die Vorrichtung 1 ist so ausgebildet, dass bei Anlage der Abstützfläche 12 an der Gehäuseinnenwand 3 die Hauptfläche 11 in einem Abstand zu dem Tragkörper 4 angeordnet ist. Dieser Abstand ist im Ausführungsbeispiel quer, insbesondere senkrecht zum Boden des Gehäuses 2 gemessen. Aufgrund des Abstands zwischen der Hauptfläche 11 und dem Tragkörper 4 kann Vergussmasse 6 zwischen dem Tragkörper 4 und die Hauptfläche 11 fließen.

Wie in Fig. 3 und insbesondere in Fig. 4 dargestellt, ist zwischen dem Zusatzkörper 7 und der Gehäuseinnenwand 3 ein erster Hohlraum 8 ausgebildet. Insbesondere ist der erste Hohlraum 8 zwischen dem Hauptkörper 20 des Zusatzkörpers 7 und der Gehäuseinnenwand 3 ausgebildet. Der erste Hohlraum 8 dient zur Aufnahme von Vergussmasse 6. Zwischen dem Zusatzkörper 7 und dem Tragkörper 4 ist ein zweiter Hohlraum 9 ausgebildet. Der zweite Hohlraum 9 ist insbesondere zwischen dem Hauptkörper 20 des Zusatzkörpers 7 und dem Tragkörper 4 ausgebildet. Der zweite Hohlraum 9 dient zur Aufnahme von Vergussmasse 6. Der Zusatzkörper 7, insbesondere der Hauptkörper 20 des Zusatzkörpers 7, trennt den ersten Hohlraum 8 zumindest abschnittsweise vom zweiten Hohlraum 9.

Der Zusatzkörper 7 umfasst insbesondere mindestens ein Abstützelement 21. Das Abstützelement 21 dient zum Abstützen des Zusatzkörpers 7 gegenüber dem Gehäuse 2, insbesondere gegenüber der Gehäuseinnenwand 3 des Gehäuses 2. Das mindestens eine Abstützelement 21 ist am Hauptkörper 20 des Tragkörpers 4 festgelegt. Der Hauptkörper 20 stützt sich über das Abstützelement 21 an der Gehäuseinnenwand 3 ab. Das Abstützelement 21 durchdringt die Vergussmasse 6 ausgehend von dem Hauptkörper 20 hin zu der Gehäuseinnenwand 3. Das Abstützelement 21 ist beidseitig von Vergussmasse 6 eingeschlossen. Die Vergussmasse 6 liegt unmittelbar an dem Abstützelement 6 an. Der Entspannungsspalt ist vollständig von Vergussmasse 6 eingeschlossen, auch wenn das Abstützelement 21 die Vergussmasse 6 durchdringt. Der Entspannungsspalt ist allseitig von Vergussmasse 6 umgeben. Im Ausführungsbeispiel sind mehrere Abstützelemente 21 vorgesehen. Die Abstützfläche 12 ist an dem Abstützelement 21 ausgebildet.

Der Zusatzkörper 7 besitzt eine Gesamtaußenfläche 10. Weniger als 40%, insbesondere weniger als 30%, im Ausführungsbeispiel weniger als 20% der Gesamtaußenfläche 10 liegen an der Gehäuseinnenwand 3 an. Eine Gesamtabstützfläche entspricht der Summe aller Abstützflächen 12. Die Gesamtabstützfläche beträgt lediglich einen Bruchteil der Hauptfläche 11. Insbesondere beträgt die Gesamtabstützfläche des Zusatzkörpers 7 weniger als 10%, im Ausführungsbeispiel weniger als 5% der Hauptfläche 11.

Weniger als 40%, insbesondere weniger als 20%, im Ausführungsbeispiel 0% der Gesamtaußenfläche 10 liegen an dem Tragkörper 4 an. Im Ausführungsbeispiel stützt sich der Zusatzkörper 7 ausschließlich an der Gehäuseinnenwand 3 ab. Ein Abstützen des Zusatzkörpers 7 gegenüber dem Tragkörper 4 ist nicht vorgesehen. Der Tragkörper 4 ist frei von einem Kontakt des Zusatzkörpers 7. Der Zusatzkörper 7 ist in einem Abstand zu dem Tragkörper 4 angeordnet.

Die Gehäuseinnenwand 3 weist eine Gesamtinnenfläche 14 auf, wie in Fig. 3 dargestellt. Die Gesamtanlagefläche 15 des Zusatzkörpers 4 beträgt weniger als 10%, im Ausführungsbeispiel weniger als 5% der Gesamtinnenfläche 14 des Gehäuses 2. Die Abstützelemente 21 des Zusatzkörpers 7 liegen nur an einem Bruchteil der Gesamtinnenfläche 14 der Gehäuseinnenwand 3 an.

Der Zusatzkörper 7 weist mindestens eine Durchlassöffnung 13 für die Vergussmasse 6 auf, wie in Fig. 1 dargestellt. Die Durchlassöffnung 13 durchdringt den Zusatzkörper 7 vollständig. Beim Vergießen der Vergussmasse 6 kann die Vergussmasse 6 durch die Durchlassöffnung 13 von der einen Seite des Zusatzkörpers 7 zu der anderen Seite des Zusatzkörpers 7 vordringen. Dadurch kann gewährleistet werden, dass auch der in Fig. 3 dargestellte erste Hohlraum 8 zwischen der Gehäuseinnenwand 3 und dem Zusatzkörper 7 mit Vergussmasse 6 gefüllt wird. Die Durchlassöffnung 13 durchdringt den Zusatzkörper 7 in Richtung quer, im Ausführungsbeispiel senkrecht zum Boden des Gehäuses 2.

Der Zusatzkörper 7 besteht zumindest teilweise, im Ausführungsbeispiel vollständig aus einem Material mit einer Wärmeleitfähigkeit von mindestens

$$0,04 \, \frac{W}{m \cdot K}$$

. Der Zusatzkörper 7 besteht zumindest teilweise, im Ausführungsbeispiel vollständig aus einem Material mit einer Wärmeleitfähigkeit von mindestens

$$0,08 \, \frac{W}{m \cdot K}$$

. Der Zusatzkörper 7 besteht zumindest teilweise, im Ausführungsbeispiel vollständig aus einem Material mit einer Wärmeleitfähigkeit von mindestens

$$0,1 \, \frac{W}{m \cdot K}$$

. Der Zusatzkörper 7 kann zumindest teilweise, insbesondere vollständig aus Papier, Metall oder Kunststoff sein. Im Ausführungsbeispiel ist der Zusatzkörper 7 vollständig aus Papier. Dadurch ist eine besonders einfache und kostengünstige Herstellung der Vorrichtung 1 möglich. Das Papier kann zur Herstellung des Hauptkörpers 20 und der Abstützelemente 21 gefaltet werden. Das Papier kann gestanzt oder lasergeschnitten werden, um den Zusatzkörper 7 herzustellen. Es kann aber auch vorgesehen sein, dass der Zusatzkörper aus einer Kunststofffolie ist. Insbesondere kann der Zusatzkörper aus Teflon oder Silikon sein.

Die Vergussmasse 6 besteht im gesamten Bereich zwischen der Gehäuseinnenwand 3 und dem Tragkörper 4 aus demselben Material, insbesondere aus derselben Werkstoffzusammensetzung. Die Vergussmasse 6 umfasst zumindest ein Harz und einen Härter. Die Mischungsverhältnisse sind im gesamten Bereich zwischen der Gehäuseinnenwand und dem Tragkörper gleich. Im Ausführungsbeispiel besitzt die Vergussmasse 6 im gesamten Bereich zwischen der Gehäuseinnenwand 3 und dem Tragkörper 4 einen einzigen Härtewert.

**Patentansprüche**

1. Vorrichtung umfassend:

   - ein Gehäuse (2) mit einer Gehäuseinnenwand (3),
   - einen Tragkörper (4) für elektronische Bauteile (5) und
   - eine Vergussmasse (6),

   wobei der Tragkörper (4) in dem Gehäuse (2) angeordnet ist, wobei die Vergussmasse (6) in dem Gehäuse (2) angeordnet ist, wobei der Tragkörper (4) zumindest teilweise in die Vergussmasse (6) eingegossen ist, wobei die Vergussmasse (6) an der Gehäuseinnenwand (3) anliegt, wobei die Vergussmasse (6) an der Gehäuseinnenwand (3) haftet, wobei die Vergussmasse (6) an dem Tragkörper (4) haftet, **dadurch gekennzeichnet, dass** die Vorrichtung (1) einen Zusatzkörper (7) umfasst, dass der Zusatzkörper (7) zwischen der Gehäuseinnenwand (3) und dem Tragkörper (4) angeordnet ist, dass der Zusatzkörper (7) eine der Gehäuseinnenwand (3) zugewandte Gehäuseseite (16) aufweist, dass zwischen der Gehäuseseite (16) des Zusatzkörpers (7) und der Gehäuseinnenwand (3) zumindest teilweise Vergussmasse (6) angeordnet ist, und dass das Material des Zusatzkörpers (7) so gewählt ist, dass sich die Vergussmasse (6) von dem Zusatzkörper (7) lösen kann.

2. Vorrichtung nach Anspruch 1, **dadurch gekennzeichnet, dass** das Material des Zusatzkörpers (7) so gewählt ist, dass sich die Vergussmasse (6) eher von dem Zusatzkörper (7) als von der Gehäuseinnenwand (3) und/oder dem Tragkörper (4) löst.

3. Vorrichtung nach Anspruch 1 oder 2, **dadurch gekennzeichnet, dass** zum Lösen der Vergussmasse (6) von dem Tragkörper (4) eine erste Lösekraft (F1) erforderlich ist, dass zum Lösen der Vergussmasse (6) von dem Zusatzkörper (7) eine zweite Lösekraft (F2) erforderlich ist, und dass die zweite Lösekraft (F2) kleiner als die erste Lösekraft (F1) ist.

4. Vorrichtung nach einem der Ansprüche 1 bis 3, **dadurch gekennzeichnet, dass** zum Lösen der Vergussmasse (6) von der Gehäuseinnenwand (3) eine dritte Lösekraft (F3) erforderlich ist, und dass die zweite Lösekraft (F2) kleiner als die dritte Lösekraft (F3) ist.

**5.** Vorrichtung nach einem der Ansprüche 1 bis 4, **dadurch gekennzeichnet, dass** zwischen dem Zusatzkörper (7) und der Gehäuseinnenwand (3) ein erster Hohlraum (8) für die Vergussmasse (6) ausgebildet ist.

**6.** Vorrichtung nach einem der Ansprüche 1 bis 5, **dadurch gekennzeichnet, dass** zwischen dem Zusatzkörper (7) und dem Tragkörper (4) ein zweiter Hohlraum (9) für die Vergussmasse (6) ausgebildet ist.

**7.** Vorrichtung nach einem der Ansprüche 1 bis 6, **dadurch gekennzeichnet, dass** der Zusatzkörper (7) eine Gesamtaußenfläche (10) besitzt, und dass weniger als 40%, insbesondere weniger als 30%, bevorzugt weniger als 20% der Gesamtaußenfläche (10) an der Gehäuseinnenwand (3) anliegen.

**8.** Vorrichtung nach einem der Ansprüche 1 bis 7, **dadurch gekennzeichnet, dass** der Zusatzkörper (7) eine Gesamtaußenfläche (10) besitzt, und dass weniger als 40%, insbesondere weniger als 20%, bevorzugt 0% der Gesamtaußenfläche (10) an dem Tragkörper (4) anliegen.

**9.** Vorrichtung nach einem der Ansprüche 1 bis 8, **dadurch gekennzeichnet, dass** der Zusatzkörper (7) eine Abstützfläche (12) zur Abstützung an der Gehäuseinnenwand (3) und eine Hauptfläche (11) umfasst, und dass die Vorrichtung (1) so ausgebildet ist, dass bei Anlage der Abstützfläche (12) an der Gehäuseinnenwand (3) die Hauptfläche (11) in einem Abstand zur Gehäuseinnenwand (3) angeordnet ist.

**10.** Vorrichtung nach einem der Ansprüche 1 bis 9, **dadurch gekennzeichnet, dass** der Zusatzkörper (7) eine Abstützfläche (12) zur Abstützung an der Gehäuseinnenwand (3) und eine Hauptfläche (11) umfasst, und dass die Vorrichtung (1) so ausgebildet ist, dass bei Anlage der Abstützfläche (12) an der Gehäuseinnenwand (3) die Hauptfläche (11) in einem Abstand zu dem Tragkörper (4) angeordnet ist.

**11.** Vorrichtung nach einem der Ansprüche 1 bis 10, **dadurch gekennzeichnet, dass** die Vergussmasse (6) im gesamten Bereich zwischen der Gehäuseinnenwand (3) und dem Tragkörper (4) aus derselben Werkstoffzusammensetzung besteht, und insbesondere dass die Vergussmasse (6) im gesamten Bereich zwischen der Gehäuseinnenwand (3) und dem Tragkörper (4) einen einzigen Härtewert besitzt.

**12.** Vorrichtung nach einem der Ansprüche 1 bis 11, **dadurch gekennzeichnet, dass** der Zusatzkörper (7) mindestens eine Durchlassöffnung (13) für die Vergussmasse (6) aufweist, und dass die Durchlassöffnung (13) den Zusatzkörper (7) vollständig durchdringt.

**13.** Vorrichtung nach einem der Ansprüche 1 bis 12, **dadurch gekennzeichnet, dass** der Zusatzkörper (7) zumindest teilweise, insbesondere vollständig aus einem Material mit einer Wärmeleitfähigkeit von mindestens $0{,}04 \dfrac{\mathrm{W}}{\mathrm{m}\cdot\mathrm{K}}$ , insbesondere von mindestens $0{,}1 \dfrac{\mathrm{W}}{\mathrm{m}\cdot\mathrm{K}}$ besteht.

**14.** Vorrichtung nach einem der Ansprüche 1 bis 13, **dadurch gekennzeichnet, dass** der Zusatzkörper (7) zumindest teilweise, insbesondere vollständig aus Papier, Metall oder Kunststoff ist.

**15.** Vorrichtung nach einem der Ansprüche 1 bis 14, **dadurch gekennzeichnet, dass** die Gehäuseinnenwand (3) eine Gesamtinnenfläche (14) aufweist, und dass der Zusatzkörper (4) mit einer Gesamtanlagefläche (15) an der Gehäuseinnenwand (3) anliegt, und dass die Gesamtanlagefläche (15) weniger als 10%, insbesondere weniger als 5% der Gesamtinnenfläche (14) beträgt.

**Geänderte Patentansprüche gemäss Regel 137(2) EPÜ.**

**1.** Vorrichtung umfassend:

- ein Gehäuse (2) mit einer Gehäuseinnenwand (3),
- einen Tragkörper (4) für elektronische Bauteile (5) und
- eine Vergussmasse (6),
wobei der Tragkörper (4) in dem Gehäuse (2) angeordnet ist, wobei die Vergussmasse (6) in dem Gehäuse (2) angeordnet ist, wobei der Tragkörper (4) zumindest teilweise in die Vergussmasse (6) eingegossen ist, wobei die Vergussmasse (6) an der Gehäuseinnenwand (3) anliegt, wobei die Vergussmasse (6) an dem Tragkörper (4) haftet, wobei die Vorrichtung (1) einen Zusatzkörper (7) umfasst, wobei der Zusatzkörper (7) zwischen der Gehäuseinnenwand (3) und dem Tragkörper (4) angeordnet ist, wobei der Zusatzkörper (7) eine der Gehäuseinnenwand (3) zugewandte Gehäuseseite (16) aufweist, wobei zwischen der Gehäuseseite (16) des Zusatzkörpers (7) und der Gehäuseinnenwand (3) zumindest teilweise Vergussmasse (6) angeordnet ist, wobei das Material des Zusatzkörpers (7) so gewählt ist, dass sich die Vergussmasse (6) während des Schwindens der Vergussmasse beim Aushärten der Vergussmasse zumindest von einem Teil des Zusatzkörpers (7) lösen kann,
**dadurch gekennzeichnet, dass** die Vergussmasse (6) an der Gehäuseinnenwand (3) haftet, dass das Material des Zusatzkörpers (7) so gewählt ist, dass sich die Vergussmasse (6) eher von dem Zusatzkörper (7) als von der Gehäuseinnenwand (3) und dem Tragkörper (4) löst, dass zum Lösen der Vergussmasse (6) von dem Tragkörper (4) eine erste Lösekraft (F1) erforderlich ist, dass zum Lösen der Vergussmasse (6) von dem Zusatzkörper (7) eine zweite Lösekraft (F2) erforderlich ist, und dass die zweite Lösekraft (F2) kleiner als die erste Lösekraft (F1) ist, dass zum Lösen der Vergussmasse (6) von der Gehäuseinnenwand (3) eine dritte Lösekraft (F3) erforderlich ist, und dass die zweite Lösekraft (F2) kleiner als die dritte Lösekraft (F3) ist.

2. Vorrichtung nach Anspruch 1,
**dadurch gekennzeichnet, dass** zwischen dem Zusatzkörper (7) und der Gehäuseinnenwand (3) ein erster Hohlraum (8) für die Vergussmasse (6) ausgebildet ist.

3. Vorrichtung nach Anspruch 1 oder 2,
**dadurch gekennzeichnet, dass** zwischen dem Zusatzkörper (7) und dem Tragkörper (4) ein zweiter Hohlraum (9) für die Vergussmasse (6) ausgebildet ist.

4. Vorrichtung nach einem der Ansprüche 1 bis 3,
**dadurch gekennzeichnet, dass** der Zusatzkörper (7) eine Gesamtaußenfläche (10) besitzt, und dass weniger als 40%, insbesondere weniger als 30%, bevorzugt weniger als 20% der Gesamtaußenfläche (10) an der Gehäuseinnenwand (3) anliegen.

5. Vorrichtung nach einem der Ansprüche 1 bis 4,
**dadurch gekennzeichnet, dass** der Zusatzkörper (7) eine Gesamtaußenfläche (10) besitzt, und dass weniger als 40%, insbesondere weniger als 20%, bevorzugt 0% der Gesamtaußenfläche (10) an dem Tragkörper (4) anliegen.

6. Vorrichtung nach einem der Ansprüche 1 bis 5,
**dadurch gekennzeichnet, dass** der Zusatzkörper (7) eine Abstützfläche (12) zur Abstützung an der Gehäuseinnenwand (3) und eine Hauptfläche (11) umfasst, und dass die Vorrichtung (1) so ausgebildet ist, dass bei Anlage der Abstützfläche (12) an der Gehäuseinnenwand (3) die Hauptfläche (11) in einem Abstand zur Gehäuseinnenwand (3) angeordnet ist.

7. Vorrichtung nach einem der Ansprüche 1 bis 6,
**dadurch gekennzeichnet, dass** der Zusatzkörper (7) eine Abstützfläche (12) zur Abstützung an der Gehäuseinnenwand (3) und eine Hauptfläche (11) umfasst, und dass die Vorrichtung (1) so ausgebildet ist, dass bei Anlage der Abstützfläche (12) an der Gehäuseinnenwand (3) die Hauptfläche (11) in einem Abstand zu dem Tragkörper (4) angeordnet ist.

8. Vorrichtung nach einem der Ansprüche 1 bis 7,
**dadurch gekennzeichnet, dass** die Vergussmasse (6) im gesamten Bereich zwischen der Gehäuseinnenwand (3) und dem Tragkörper (4) aus derselben Werkstoffzusammensetzung besteht, und insbesondere dass die Vergussmasse (6) im gesamten Bereich zwischen der Gehäuseinnenwand (3) und dem Tragkörper (4) einen einzigen Härtewert besitzt.

9. Vorrichtung nach einem der Ansprüche 1 bis 8,
**dadurch gekennzeichnet, dass** der Zusatzkörper (7) mindestens eine Durchlassöffnung (13) für die Vergussmasse (6) aufweist, und dass die Durchlassöffnung (13) den Zusatzkörper (7) vollständig durchdringt.

10. Vorrichtung nach einem der Ansprüche 1 bis 9,
**dadurch gekennzeichnet, dass** der Zusatzkörper (7) zumindest teilweise, insbesondere vollständig aus einem Material mit einer Wärmeleitfähigkeit von mindestens $0{,}04\frac{\mathrm{W}}{\mathrm{m}\cdot\mathrm{K}}$, insbesondere von mindestens $0{,}1\frac{\mathrm{W}}{\mathrm{m}\cdot\mathrm{K}}$ besteht.

11. Vorrichtung nach einem der Ansprüche 1 bis 10,
**dadurch gekennzeichnet, dass** der Zusatzkörper (7) zumindest teilweise, insbesondere vollständig aus Papier, Metall oder Kunststoff ist.

12. Vorrichtung nach einem der Ansprüche 1 bis 11,
**dadurch gekennzeichnet, dass** die Gehäuseinnenwand (3) eine Gesamtinnenfläche (14) aufweist, und dass der Zusatzkörper (4) mit einer Gesamtanlagefläche (15) an der Gehäuseinnenwand (3) anliegt, und dass die Gesamtanlagefläche (15) weniger als 10%, insbesondere weniger als 5% der Gesamtinnenfläche (14) beträgt.

*Fig. 1*

*Fig. 2*

Fig. 3

*Fig. 4*

EP 4 376 563 A1

Europäisches Patentamt
European Patent Office
Office européen des brevets

# EUROPÄISCHER RECHERCHENBERICHT

**Nummer der Anmeldung**

EP 22 20 9817

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2016 202640 A1 (ZAHNRADFABRIK FRIEDRICHSHAFEN [DE]) 24. August 2017 (2017-08-24) * Absatz [0004] – Absatz [0040] * * Abbildungen 1-3 * | 1-15 | INV. H05K5/06 |
| X | WO 2015/188383 A1 (DOW CORNING [US]; DOW CORNING CHINA HOLDING CO LTD [CN]) 17. Dezember 2015 (2015-12-17) * Absatz [0019] – Absatz [0045] * * Abbildung 5 * | 1-15 | |
| X | DE 102 35 047 A1 (ENDRESS & HAUSER GMBH & CO KG [DE]) 12. Februar 2004 (2004-02-12) * Absatz [0018] – Absatz [0021] * * Abbildung 1 * | 1-15 | |
| X | US 2016/268070 A2 (SCHMERSAL K A HOLDING GMBH & CO KG [DE]) 15. September 2016 (2016-09-15) * Absatz [0004] – Absatz [0017] * * Anspruch 1 * * Abbildungen 1-2 * | 1-15 | |
| X | WO 2014/146614 A1 (DOW CORNING CHINA HOLDING CO LTD [CN]; DOW CORNING [US]) 25. September 2014 (2014-09-25) | 1-5, 7-11, 13-15 | |
| A | * Absatz [0018] – Absatz [0028] * * Abbildungen 1-3 * | 6,12 | |
| A | US 2011/053526 A1 (STREI DAVID MATTHEW [US] ET AL) 3. März 2011 (2011-03-03) * Absatz [0024] – Absatz [0036] * * Abbildungen 3-5 * | 1-15 | |

**RECHERCHIERTE SACHGEBIETE (IPC)**

H05K

Der vorliegende Recherchenbericht wurde für alle Patentansprüche erstellt

| Recherchenort | Abschlußdatum der Recherche | Prüfer |
|---|---|---|
| Den Haag | 26. April 2023 | Jorna, Pieter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

14

## ANHANG ZUM EUROPÄISCHEN RECHERCHENBERICHT
## ÜBER DIE EUROPÄISCHE PATENTANMELDUNG NR.

EP 22 20 9817

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-04-2023

| Im Recherchenbericht angeführtes Patentdokument | Datum der Veröffentlichung | Mitglied(er) der Patentfamilie | Datum der Veröffentlichung |
|---|---|---|---|
| DE 102016202640 A1 | 24-08-2017 | KEINE | |
| WO 2015188383 A1 | 17-12-2015 | KEINE | |
| DE 10235047 A1 | 12-02-2004 | AT 468009 T | 15-05-2010 |
| | | AU 2003250103 A1 | 23-02-2004 |
| | | CN 1672477 A | 21-09-2005 |
| | | DE 10235047 A1 | 12-02-2004 |
| | | EP 1525783 A1 | 27-04-2005 |
| | | US 2006120054 A1 | 08-06-2006 |
| | | WO 2004014116 A1 | 12-02-2004 |
| US 2016268070 A2 | 15-09-2016 | CA 2859088 A1 | 20-06-2013 |
| | | DE 102011121045 B3 | 22-11-2012 |
| | | EP 2792225 A2 | 22-10-2014 |
| | | US 2015090567 A1 | 02-04-2015 |
| | | WO 2013087160 A2 | 20-06-2013 |
| WO 2014146614 A1 | 25-09-2014 | TW 201505329 A | 01-02-2015 |
| | | WO 2014146614 A1 | 25-09-2014 |
| US 2011053526 A1 | 03-03-2011 | BR 112012004840 A2 | 29-08-2017 |
| | | CN 102369792 A | 07-03-2012 |
| | | EP 2474215 A1 | 11-07-2012 |
| | | JP 5480384 B2 | 23-04-2014 |
| | | JP 2013504207 A | 04-02-2013 |
| | | US 2011053526 A1 | 03-03-2011 |
| | | WO 2011028750 A1 | 10-03-2011 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011086048 A1